# EUROPEAN PATENT APPLICATION

(11) **EP 4 723 814 A1**
(43) Date of publication of application: **08.04.2026**
(21) Application number: 23940528.5
(22) Date of filing: 28.12.2023
(51) Int. Cl.: H05K 5/02, H05K 5/03, H02M 7/00

(54) **HOUSING FOR ELECTRICAL DEVICE, AND PHOTOVOLTAIC INVERTER**

(30) Priority: 05.06.2023 CN 202321424668 U
(71) Applicant: Huawei Digital Power Technologies Co., Ltd., Shenzhen, Guangdong 518043 (CN)
(72) Inventor: CHEN, Shichao, Shenzhen, Guangdong 518043 (CN); LIANG, Chengchen, Shenzhen, Guangdong 518043 (CN); LIU, Lin, Shenzhen, Guangdong 518043 (CN); ZHANG, Mingyuan, Shenzhen, Guangdong 518043 (CN)
(74) Representative: Gill Jennings & Every LLP
(86) International application number: PCT/CN2023/142990
(87) International publication number: WO 2024/250654

(57) **Abstract**

This application provides a housing for a power device, and a photovoltaic inverter, which are used in an electronic device. The housing includes a bottom plate, a cover, two first side plates, and two second side plates. The bottom housing and the cover are arranged opposite to each other along a first direction. The two first side plates are arranged opposite to each other along a second direction. The two second side plates are arranged opposite to each other along a third direction. The first direction, the second direction, and the third direction are perpendicular to each other. The cover is connected to at least one of the two first side plates in a first fastening manner. The cover is connected to at least one of the two second side plates in a second fastening manner. A fastening force of the first fastening manner is different from a fastening force of the second fastening manner. The photovoltaic inverter provided in this application includes an electrical component and the foregoing housing for a power device. The housing is configured to accommodate the electrical component, and the electrical component includes a plurality of power transistors. According to the housing for a power device and the photovoltaic inverter, a problem that a cover of an existing photovoltaic inverter is likely to fly off when pressure in a housing reaches a specific degree is mitigated.

## Description

This application claims priority to Chinese Patent Application No. 202321424668.X, filed with the China National Intellectual Property Administration on June 5, 2023 and entitled **"HOUSING FOR POWER DEVICE, AND PHOTOVOLTAIC INVERTER",** which is incorporated herein by reference in its entirety.

### TECHNICAL FIELD

This application relates to the field of power device technologies, and in particular, to a housing for a power device, and a photovoltaic inverter.

### BACKGROUND

A photovoltaic inverter is one of core components of a photovoltaic power generation system. Specifically, the photovoltaic inverter includes an electrical component and a housing. The housing includes a box and a cover. The box and the cover cooperatively enclose accommodation space with good air tightness. The electrical component is disposed in the accommodation space with good air tightness. In this way, the photovoltaic inverter meets requirements for waterproofing, dustproofing, and the like. However, the photovoltaic inverter usually has a large quantity of internal electrolytic capacitor components. In an abnormal case, a large amount of flammable gas is produced due to gasification of an electrolyte, resulting in high flammability and explosibility. A disadvantage of the existing structure lies in that, when an explosion occurs in an abnormal case, pressure in the housing sharply increases instantaneously, and the cover is detached from the box and flies off due to strong pressure. This is likely to cause damage to surrounding persons and devices.

### UTILITY MODEL CONTENT

This application provides a housing for a power device, and a photovoltaic inverter, to mitigate a problem that a cover of an existing photovoltaic inverter is likely to fly off when pressure in a housing sharply increases instantaneously.

According to a first aspect, this application provides a housing for a power device. The housing includes a bottom plate, a cover, two first side plates, and two second side plates. The bottom housing and the cover are arranged opposite to each other along a first direction. The two first side plates are arranged opposite to each other along a second direction. The two second side plates are arranged opposite to each other along a third direction. The first direction, the second direction, and the third direction are perpendicular to each other.

The cover is connected to at least one of the two first side plates in a first fastening manner. The cover is connected to at least one of the two second side plates in a second fastening manner. A fastening force of the first fastening manner is different from a fastening force of the second fastening manner.

In this solution, when the cover is subject to large pressure, the cover can be deformed to absorb specific energy. In addition, after the cover is pushed up by a specific distance, the inside of the housing is in communication with an external environment, to relieve pressure. In this way, when pressure in the housing is large, accumulated energy can be absorbed and released, to reduce a possibility that the cover flies off.

In an optional technical solution, lengths of the two first side plates along the third direction are less than lengths of the two second side plates along the second direction.

In an optional technical solution, the fastening force of the first fastening manner is less than the fastening force of the second fastening manner. In this way, the cover can be reliably connected to the second side plate, and a gap can also be formed between the cover and the first side plate when pressure in the housing reaches a specific degree, to absorb energy and relieve pressure.

In an optional technical solution, the fastening force of the first fastening manner is greater than the fastening force of the second fastening manner.

In an optional technical solution, the bottom plate, the two first side plates, and the two second side plates enclose an accommodation cavity, and the accommodation cavity is configured to accommodate an electrical component, where
each first side plate is connected to the two second side plates in a third fastening manner, the bottom plate is connected to the two first side plates and the two second side plates in the third fastening manner, and at least one of the fastening force of the first fastening manner or the fastening force of the second fastening manner is less than a fastening force of the third fastening manner. In this way, when pressure in the housing reaches a specific degree, the cover is deformed when the accommodation cavity is intact, and a gap is formed between the cover and a corresponding first side plate or second side plate, to absorb energy and relieve pressure.

In an optional technical solution, the third fastening manner includes welding or integral forming, the two pairs of side plates are sequentially fastened to each other, and each side plate is fastened to the bottom plate, so that connections between adjacent side plates and between each side plate and the bottom plate are more reliable.

In an optional technical solution, the first fastening manner includes a plurality of first fastening units, each first fastening unit includes a first screw, a first nut, and a first gasket, and the first nut is configured to connect to the first screw in a threaded manner; and
the second fastening manner includes a plurality of second fastening units, each second fastening unit includes a second screw, a second nut, a reinforcing piece, and a second gasket, and the second nut is configured to connect to the second screw in a threaded manner.

In an optional technical solution, at least one of the two first side plates includes a first flanging structure, the first flanging structure is arranged on an outer side of the housing, a projection of the cover covers a projection of the first flanging structure along the first direction, the first flanging structure includes a plurality of first through holes, and the plurality of first through holes are sequentially arranged at spacings on the first flanging structure along the third direction, where
each first through hole penetrates the first flanging structure along the first direction, each first through hole is configured to accommodate a first screw of one first fastening unit, a first nut and a first gasket of the first fastening unit are separately sleeved on the first screw, and the first gasket, the cover, the first flanging structure, and the first nut are sequentially stacked along the first direction.

In an optional technical solution, at least one of the two second side plates includes a second flanging structure, the second flanging structure is arranged on an outer side of the housing, a projection of the cover covers a projection of the second flanging structure along the first direction, the second flanging structure includes a plurality of second through holes, and the plurality of second through holes are arranged at spacings along the second direction, where
each second through hole penetrates the second flanging structure along the first direction, each second through hole is configured to accommodate a second screw of one second fastening unit, a second nut, a second gasket, and a reinforcing piece of the second fastening unit are separately sleeved on the first screw, and the second gasket, the cover, the second flanging structure, the reinforcing piece, and the second nut are sequentially stacked along the first direction. The reinforcing piece is disposed, so that local stress near the second through hole can be reduced, to alleviate a trend of displacement of the second nut along a direction facing away from the bottom plate, and ensure a reliable connection between the cover and the second flanging structure.

In an optional technical solution, the cover includes at least one third flanging structure, and a projection of each third flanging structure covers the first flanging structure or the second flanging structure along the first direction.

In an optional technical solution, each third flanging structure includes a plurality of fourth through holes, where
along the first direction, each fourth through hole penetrates one third flanging structure, and a projection of each fourth through hole overlaps a projection of one first through hole or a projection of one second through hole.

In an optional technical solution, the housing includes a sealing ring, and the sealing ring is disposed at joints between the cover and the two first side plates and between the cover and the two second side plates, to implement sealing between the cover and the first side plates and between the cover and the second side plates, and achieve waterproof and dustproof effect.

In an optional technical solution, a conducting layer is disposed on an inner surface of the sealing ring, and the cover is electrically connected to the two first side plates and the two second side plates through the conducting layer, to achieve better EMC shielding effect between the cover and the first side plates and between the cover and the second side plates.

According to a second aspect, this application provides a photovoltaic inverter. The photovoltaic inverter includes an electrical component and any one of the foregoing housings for a power device. The housing is configured to accommodate the electrical component, and the electrical component includes a plurality of power transistors. In the photovoltaic inverter, a possibility that a cover flies off can be reduced.

### BRIEF DESCRIPTION OF DRAWINGS

FIG. 1 is a diagram of a photovoltaic inverter according to an embodiment of this application;
FIG. 2 is a three-dimensional diagram of a structure of a housing for a power device according to an embodiment of this application;
FIG. 3 is a diagram of a structure of a housing for a power device in a case in which a cover is pushed up by a specific distance according to an embodiment of this application, where the cover is connected to one first side plate in a first fastening manner;
FIG. 4 is a diagram of a structure of a housing for a power device in a case in which a cover is pushed up by a specific distance according to another embodiment of this application, where the cover is connected to two first side plates in a first fastening manner;
FIG. 5 is a diagram of a structure of a housing for a power device in a case in which a cover is pushed up by a specific distance according to an embodiment of this application, where the cover is connected to one second side plate in a second fastening manner;
FIG. 6 is a diagram of a structure of a housing for a power device in a case in which a cover is pushed up by a specific distance according to another embodiment of this application, where the cover is connected to two second side plates in a second fastening manner;
FIG. 7 is a diagram of a structure of a housing for a power device according to an embodiment of this application;
FIG. 8 is a cross-sectional view of a housing shown in FIG. 7 at a position B-B;
FIG. 9 is a cross-sectional view of a housing shown in FIG. 7 at a position C-C;
FIG. 10 is a diagram of a structure of a reinforcing piece and a second nut in a housing according to an embodiment of this application;
FIG. 11 is a diagram of a sealing ring in a housing according to an embodiment of this application; and
FIG. 12 is a cross-sectional view of a sealing ring in a housing according to an embodiment of this application.

Reference numerals: 1: bottom plate; 2: cover; 21: third flanging structure; 211: fourth through hole; 3: first side plate; 31: first flanging structure; 4: second side plate; 41: second flanging structure; 411: second through hole; 5: first fastening unit; 51: first screw; 52: first nut; 53: first gasket; 54: first elastic washer; 6: second fastening unit; 61: second screw; 62: second nut; 63: reinforcing piece; 64: second gasket; 65: second elastic washer; 7: sealing ring; 8: conducting layer; 9: electrical component; 100: housing.

### DESCRIPTION OF EMBODIMENTS

A photovoltaic inverter is one of core components of a photovoltaic power generation system, and plays an important role in the photovoltaic power generation system. It is well known that good air tightness is a basic requirement for an inverter housing. However, because the housing has good air tightness, pressure accumulated in an inner cavity of the housing cannot be released. When the pressure reaches a specific degree due to various factors, a cover flies off from a box under the strong pressure. This poses a large threat to persons and devices around the photovoltaic inverter.

Based on this, embodiments of this application provide a housing for a power device, and a photovoltaic inverter, to resolve the foregoing problem. To make objectives, technical solutions, and advantages of this application clearer, the following further describes this application in detail with reference to the accompanying drawings.

Terms used in the following embodiments are merely intended to describe specific embodiments, but not to limit this application. The terms "an", "a", "the", "the foregoing", and "this" of singular forms used in this specification and the appended claims of this application are also intended to include expressions such as "one or more", unless otherwise specified in the context clearly.

Reference to "an embodiment", "some embodiments", or the like described in this specification means that one or more embodiments of this application includes/include a specific feature, structure, or characteristic described with reference to the embodiment. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "comprise", "have", and their variants all mean "include but are not limited to", unless otherwise specifically emphasized in another manner.

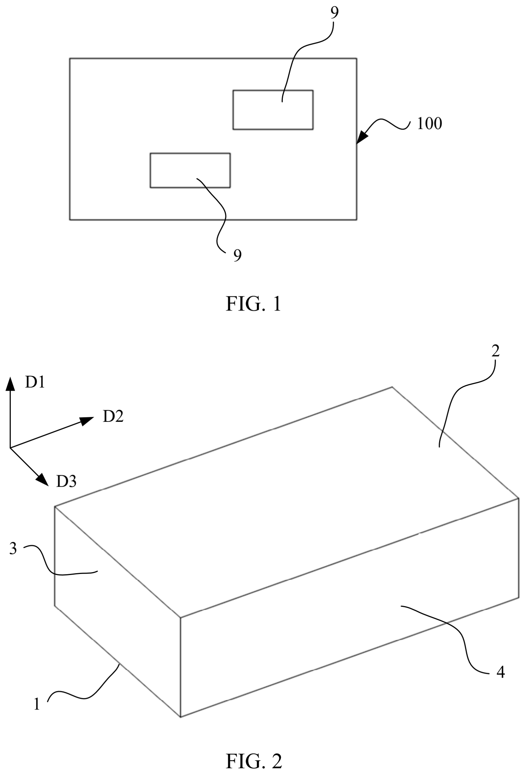

FIG. 1 is a diagram of a photovoltaic inverter according to an embodiment of this application. As shown in FIG. 1, the photovoltaic inverter includes an electrical component 9 and a housing 100 for a power device. The housing 100 has an accommodation cavity. The electrical component 9 includes a plurality of power transistors. The electrical component 9 is disposed in the accommodation cavity of the housing 100, so that the electrical component 9 is protected by the housing 100. FIG. 2 is a three-dimensional diagram of a structure of a housing for a power device according to an embodiment of this application. As shown in FIG. 2, the housing 100 includes a bottom plate 1, a cover 2, two first side plates 3, and two second side plates 4. Specifically, the bottom plate 1 and the cover 2 are arranged opposite to each other along a first direction D1, the two first side plates 3 are arranged opposite to each other along a second direction D2, and the two second side plates 4 are arranged opposite to each other along a third direction D3. The first direction D1, the second direction D2, and the third direction D3 are perpendicular to each other. Further, the cover 2 is fastened to all of the first side plates 3 and the second side plates 4. For example, the cover 2 is connected to one of the two first side plates 3 in a first fastening manner, or the cover 2 is connected to both of the two first side plates 3 in a first fastening manner; and the cover 2 is connected to one of the two second side plates 4 in a second fastening manner, or the cover 2 is connected to both of the two second side plates 4 in a second fastening manner. It should be noted that a fastening force of the first fastening manner is different from a fastening force of the second fastening manner. To be specific, the fastening force of the first fastening manner is less than or greater than the fastening force of the second fastening manner. To be specific, a fastening force between the cover 2 and the first side plate 3 connected to the cover 2 in the first fastening manner is less than or greater than a fastening force between the cover 2 and the second side plate 4 connected to the cover 2 in the second fastening manner.

For ease of description, in the following embodiments, a first side plate 3 connected to the cover 2 in the first fastening manner is referred to as a first side plate A, and a second side plate 4 connected to the cover 2 in the second fastening manner is referred to as a second side plate A. In the foregoing solution, a fastening force of a connection between the cover 2 and the first side plate A is different from a fastening force of a connection between the cover 2 and the second side plate A. In this way, when the cover 2 is subject to large pressure, for example, when pressure in the housing sharply increases instantaneously, the cover 2 can be reliably connected to a corresponding first side plate A or second side plate A at a position with a large fastening force. At a position with a small fastening force, the cover 2 can be deformed and pushed up by a specific distance, so that a gap is formed between the cover 2 and a corresponding second side plate A or first side plate A, to enable communication between the inside of the housing 100 and an external environment. Because the cover 2 is pushed up by a specific distance, the cover 2 can absorb specific energy because of the deformation. In addition, after the cover 2 is pushed up by a specific distance, the inside of the housing 100 is in communication with the external environment, to relieve pressure. In this way, when pressure in the housing 100 is large, accumulated energy can be absorbed and released, to reduce a possibility that the cover 2 flies off.

Specifically, during arrangement of the first side plates 3 and the second side plates 4, in an optional implementation, a length of each first side plate 3 along the third direction D3 is less than a length of each second side plate 4 along the second direction D2. Certainly, in another implementation, a length of each first side plate 3 along the third direction D3 may alternatively be greater than or equal to a length of each second side plate 4 along the second direction D2.

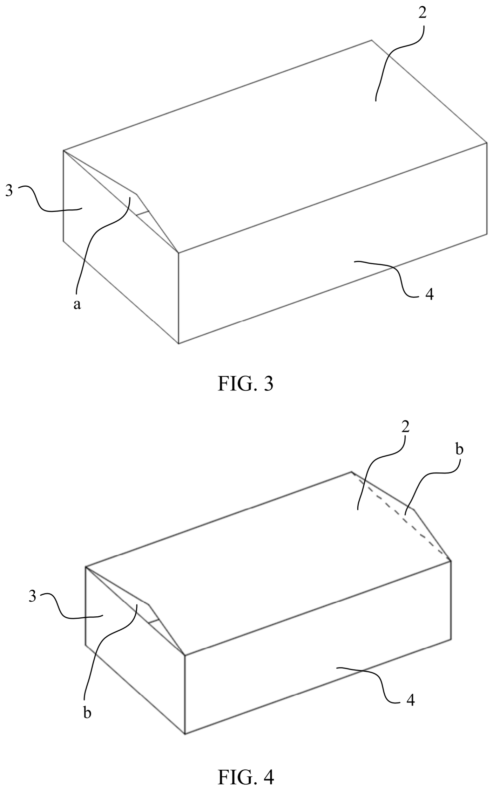

For example, the length of each first side plate 3 along the third direction D3 is less than the length of each second side plate 4 along the second direction D2. In a specific implementation, a fastening force between the cover 2 and the first side plate A is less than a fastening force between the cover 2 and the second side plate A. That is, the fastening force of the first fastening manner is less than the fastening force of the second fastening manner. In this solution, a length of the second side plate A is larger, and the fastening force between the cover 2 and the second side plate A is greater than the fastening force between the cover 2 and the first side plate A. In this way, on the basis that the cover 2 is deformed to absorb energy and pressure is relieved through a gap between the cover 2 and the first side plate A, a connection between the cover and the second side plate A is also more reliable. This helps further reduce a possibility that the cover 2 flies off. The following provides specific descriptions with reference to specific embodiments. FIG. 3 is a diagram of a structure of a housing for a power device in a case in which a cover is pushed up by a specific distance according to an embodiment of this application. It should be noted that, in this embodiment, the cover 2 is connected to one first side plate 3 in a first fastening manner. As shown in FIG. 3, a part, corresponding to the first side plate 3, of the cover 2 is deformed, and a gap a is formed between the cover 2 and the first side plate 3. FIG. 4 is a diagram of a structure of a housing for a power device in a case in which a cover is pushed up by a specific distance according to another embodiment of this application. It should be noted that, in this embodiment, the cover 2 is connected to two first side plates 3 in a first fastening manner. As shown in FIG. 4, a part, corresponding to each first side plate 3, of the cover 2 is deformed, and a gap b is formed between the cover 2 and each first side plate 3. In this solution, deformation may occur at both ends of the cover 2, and a gap is formed between each of the two ends of the cover 2 and a corresponding first side plate 3. Therefore, better energy absorption and pressure relief effect is achieved, and a possibility that the cover 2 flies off is greatly reduced.

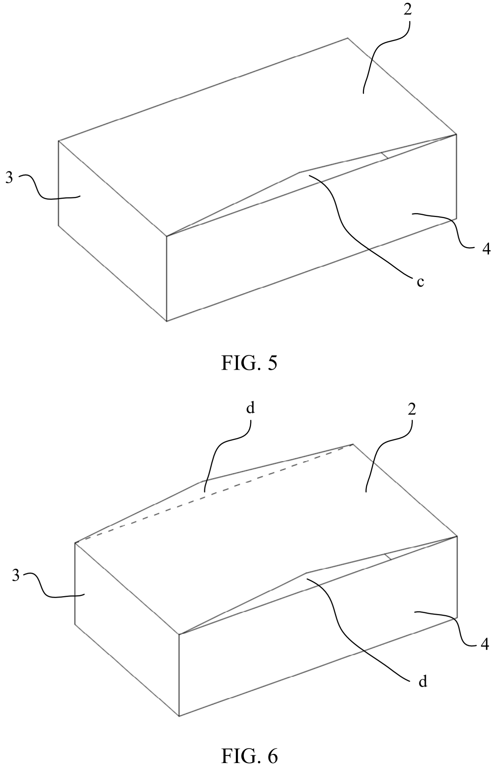

Still, for example, the length of each first side plate 3 along the third direction D3 is less than the length of each second side plate 4 along the second direction D2. In another specific implementation, the fastening force of the first fastening manner is greater than the fastening force of the second fastening manner. The following provides specific descriptions with reference to specific embodiments. FIG. 5 is a diagram of a structure of a housing for a power device in a case in which a cover is pushed up by a specific distance according to an embodiment of this application. It should be noted that, in this embodiment, the cover 2 is connected to one second side plate 4 in a second fastening manner. As shown in FIG. 5, a part, corresponding to the second side plate A, of the cover 2 is deformed, and a gap c is formed between the cover 2 and the second side plate A. FIG. 6 is a diagram of a structure of a housing for a power device in a case in which a cover is pushed up by a specific distance according to another embodiment of this application. It should be noted that, in this embodiment, the cover 2 is connected to two second side plates 4 in a second fastening manner. As shown in FIG. 6, a part, corresponding to each second side plate 4, of the cover 2 is deformed, and a gap d is formed between the cover 2 and each second side plate 4. In this solution, deformation may occur at both ends of the cover 2, and a gap is formed between each of the two ends of the cover 2 and a corresponding second side plate 4. Therefore, better energy absorption and pressure relief effect is achieved, and a possibility that the cover 2 flies off is lower.

In an optional implementation, the bottom plate 1, the two first side plates 3, and the two second side plates 4 enclose an accommodation cavity for accommodating the electrical component 9. To be specific, the housing 100 is in a cuboid shape or a cube shape. Specifically, each first side plate 3 is connected to the two second side plates 4 in a third fastening manner, and the bottom plate 1 is connected to the two first side plates 3 and the two second side plates 4 in the third fastening manner, to enclose the accommodation cavity. At least one of the fastening force of the first fastening manner or the fastening force of the second fastening manner is less than a fastening force of the third fastening manner. In this way, when pressure in the housing 100 reaches a specific degree, the cover 2 is deformed when the accommodation cavity is intact, and a gap is formed between the cover 2 and a corresponding first side plate A or second side plate A, to absorb energy and relieve pressure. For example, the third fastening manner includes welding or integral forming, the two pairs of side plates are sequentially fastened to each other, and each side plate is fastened to the bottom plate 1. For example, adjacent side plates are connected through welding, and each side plate is also connected to the bottom plate through welding; or the bottom plate 1, the two first side plates 3, and two second plate bodies are integrally formed, for example, through 3D printing or deep drawing. Certainly, a manner connecting adjacent side plates and connecting each side plate to the bottom plate is not limited thereto. For example, the bottom plate 1 and the two first side plates 3 or the two second plate bodies are of a U-shaped structure formed by bending a same plate, and correspondingly, the two second side plates 4 or first side plates 3 are welded at two ends of the U-shaped structure.

Certainly, the housing 100 is not limited to the cuboid shape or the cube shape. In another implementation, the housing 100 may alternatively be of a cylindrical structure with a cross section in a pentagonal shape or hexagonal shape. Details are not described herein.

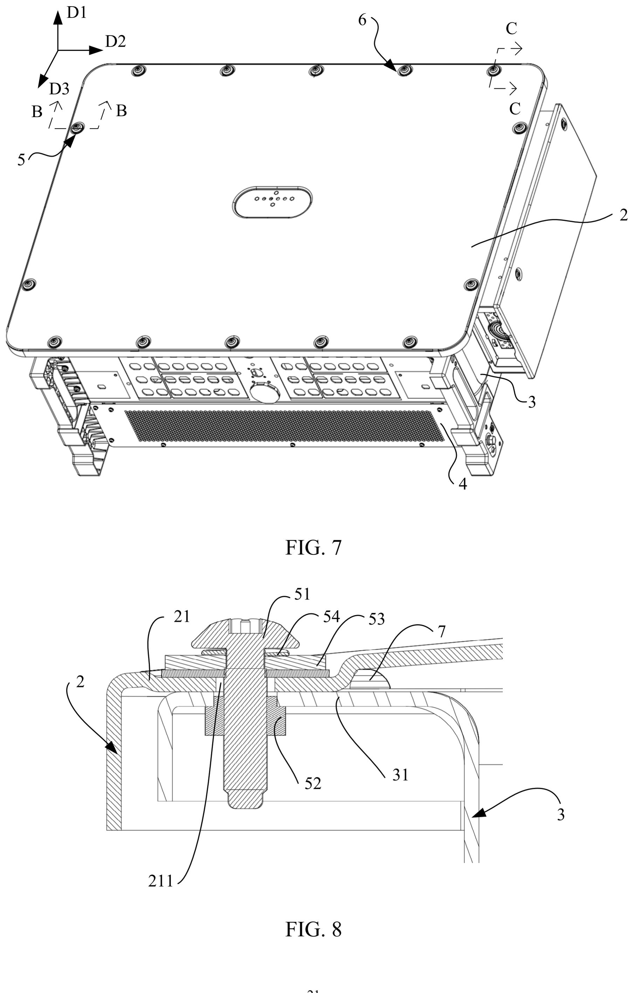

FIG. 7 is a diagram of a structure of a housing for a power device according to an embodiment of this application. FIG. 8 is a cross-sectional view of the housing shown in FIG. 7 at a position B-B. With reference to FIG. 7 and FIG. 8, at least one of two first side plates 3 includes a first flanging structure 31, the first flanging structure 31 is located on an outer side of the housing 100, and a projection of a cover 2 covers a projection of the first flanging structure 31 along a first direction D1. Further, the first flanging structure 31 includes a plurality of first through holes, the plurality of first through holes are sequentially arranged at spacings on the first flanging structure 31 along a third direction D3, and each first through hole penetrates the first flanging structure 31 along the first direction D1. A first fastening manner includes a plurality of first fastening units 5, and each first fastening unit 5 includes a first screw 51, a first nut 52, and a first gasket 53. Each first through hole corresponds to one first fastening unit 5. One first through hole and a first fastening unit 5 corresponding to the first through hole are used as an example. Specifically, a first screw 51 is accommodated in the first through hole, a first nut 52 and a first gasket 53 are separately sleeved on the first screw 51, the first gasket 53, the cover 2, the first flanging structure 31, and the first nut 52 are sequentially stacked along the first direction D1, and the first nut 52 is connected to the first screw 51 in a threaded manner. To be specific, the first nut 52 is fastened to a side, facing away from the cover 2, of the first flanging structure 31; the first gasket 53 is located on a side, facing away from the first flanging structure 31, of the cover 2; and a threaded part of the first screw 51 sequentially passes through the first gasket 53, the cover 2, and the first through hole, and is connected to the first nut 52 in a threaded manner. For example, the first nut 52 is fastened to the side, facing away from the cover 2, of the first flanging structure 31 through riveting. In this solution, the first screw 51, the first gasket 53, and the first nut 52 match each other to ensure a reliable connection between the cover 2 and the first side plate 3 when pressure in the housing 100 is normal. In addition, when a fastening force between the cover 2 and a first side plate A is less than a fastening force between the cover 2 and a second side plate A, and when pressure in the housing is large, the first nut 52 can be lifted by a specific distance under the action of the cover 2 and the first screw 51, the cover 2 can be deformed under the action of the pressure in the housing 100, and a gap for pressure relief is formed between the cover 2 and the first side plate A.

In a specific implementation, a first elastic washer 54 may be further disposed between the first gasket 53 and a head of the first screw 51, and the first elastic washer 54 is sleeved on the first screw 51.

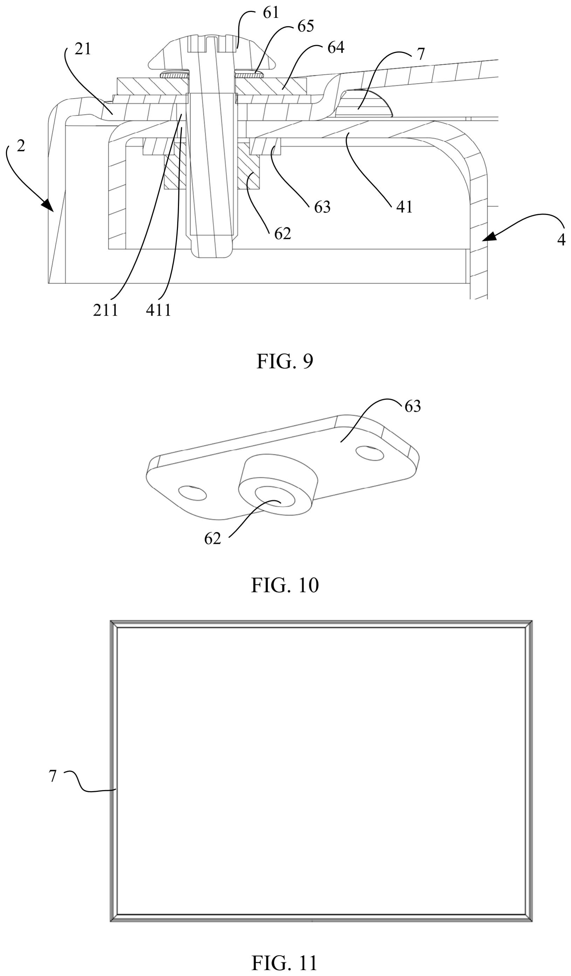

FIG. 9 is a cross-sectional view of the housing 100 shown in FIG. 7 at C-C. With reference to FIG. 7 and FIG. 9, at least one of two second side plates 4 includes a second flanging structure 41, the second flanging structure 41 is located on an outer side of the housing 100, and a projection of a cover 2 covers a projection of the second flanging structure 41 along a first direction D1. Specifically, the second flanging structure 41 includes a plurality of second through holes 411, the plurality of second through holes 411 are sequentially arranged at spacings along a second direction D2, and each second through hole 411 penetrates the second flanging structure 41 along the first direction D1. A second fastening manner includes a plurality of second fastening units 6, and each second fastening unit 6 includes a second screw 61, a second nut 62, a reinforcing piece 63, and a second gasket 64. Each second through hole 411 corresponds to one second fastening unit 6. Specifically, one second through hole 411 and a second fastening unit 6 corresponding to the second through hole are used as an example. A second screw 61 of the second fastening unit 6 sequentially passes through a second gasket 64, the cover 2, the second through hole 411, and a reinforcing piece 63, and is connected to a second nut 62 in a threaded manner. When pressure in the housing 100 increases, a force applied to the cover 2 along a direction facing away from a bottom plate 1 increases, and a force applied by the second nut 62 to the second flanging structure 41 also increases. The reinforcing piece 63 is disposed, so that an action area between the second nut 62 and the second flanging structure 41 increases, and local stress near the second through hole 411 can be reduced, to alleviate a trend of displacement of the second nut 62 along a direction facing away from the bottom plate 1, and ensure a reliable connection between the cover 2 and the second flanging structure 41. For example, the reinforcing piece 63 may be a steel sheet, the reinforcing piece 63 may be fastened to the second flanging structure 41 by using a screw, a pin, or the like, and the second nut 62 may be fastened to the reinforcing piece 63 through riveting, as shown in FIG. 10. Certainly, a manner of fastening the second flanging structure 41 to the cover 2 is not limited to the foregoing solution, and the second flanging structure 41 may alternatively be connected to the cover 2 through riveting or the like.

In a specific implementation, a second elastic washer 65 may be further disposed between the second gasket 64 and a head of the second screw 61, and the second elastic washer 65 is sleeved on the second screw 61.

Still refer to FIG. 8 and FIG. 9. The cover 2 of the housing 100 includes at least one third flanging structure 21, and a projection of each third flanging structure 21 covers a corresponding first flanging structure 31 or second flanging structure 41 along the first direction D1. For example, each third flanging structure 21 includes a plurality of fourth through holes 211. Along the first direction D1, each fourth through hole 211 penetrates one third flanging structure 21, and a projection of each fourth through hole 211 overlaps a projection of a corresponding first through hole or a projection of a corresponding second through hole 411. That is, the third flanging structure 21 of the cover 2 is connected to the corresponding first flanging structure 31 or second flanging structure 41 through the fourth through hole 211.

In a specific implementation, the two first side plates 3 each include a first flanging structure 31, the two second side plates 4 each include a second flanging structure 41, the cover 2 includes four third flanging structures 21, and projections of the four third flanging structures 21 each cover a flanging structure of one side plate along the first direction D1. The two first side plates 3 each are connected to a corresponding third flanging structure 21 in the first fastening manner, the two second side plates 4 each are connected to a corresponding third flanging structure 21 in the second fastening manner, a fastening force of the first fastening manner is less than a fastening force of the second fastening manner, and lengths of the two first side plates 3 along the third direction D3 are less than lengths of the two second side plates 4 along the second direction D2. That is, the housing 100 is in a cuboid shape, and a fastening force between the cover 2 and a shorter side plate, that is, the first side plate 3, is less than a fastening force between the cover 2 and a longer edge, that is, the second side plate 4. In this solution, when pressure in the housing 100 reaches a specific degree, a possibility that the cover 2 flies off can be reduced through a connection between the cover 2 and the second side plate 4, and the cover 2 can also be deformed at a position at which the cover 2 matches the first side plate 3 to form a gap for pressure relief between the cover 2 and the first side plate 3.

Further, a distance between two adjacent first through holes on the first flanging structure 31 is greater than a distance between two adjacent second through holes 411 on the second flanging structure 41, and a quantity of first through holes on the first flanging structure 31 is less than a quantity of second through holes 411 on the second flanging structure 41. In this way, a gap for pressure relief is more likely to be formed between the cover 2 and the first flanging structure 31 at a position at which the cover 2 matches the first flanging structure 31, and a connection between the cover 2 and the second flanging structure 41 is more reliable.

When the housing 100 is specifically disposed, the housing 100 includes a sealing ring 7. The sealing ring 7 is located at joints between the cover 2 and the two first side plates 3 and between the cover 2 and the two second side plates 4, to implement sealing and matching between the cover 2 and the first side plates 3 and between the cover 2 and the second side plates 4, to protect the electrical component 9 in the housing 100.

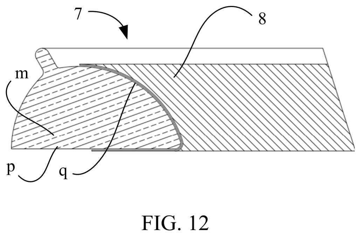

FIG. 11 is a diagram of a sealing ring in a housing according to an embodiment of this application. FIG. 12 is a cross-sectional view of a sealing ring in a housing according to an embodiment of this application. As shown in FIG. 11 and FIG. 12, in an optional implementation, a conducting layer 8 is disposed on an inner surface of the sealing ring 7, and a cover 2 is electrically connected to two first side plates 3 and two second side plates 4 through the conducting layer 8, so that continuous conduction is implemented between the cover 2, the first side plates 3, and the second side plates 4. This achieves better electromagnetic compatibility (Electromagnetic Compatibility, EMC) shielding effect, and better guarantees performance of a photovoltaic inverter.

Still refer to FIG. 12. When the sealing ring 7 is specifically disposed, a longitudinal cross section m of the sealing ring 7 may be in a semicircular shape. To be specific, the sealing ring 7 includes a flat surface p and an arc surface q. The flat surface p of the sealing ring 7 is attached to a first flanging structure 31 and a second flanging structure 41, and conductive fabrics are disposed on a part, facing an accommodation cavity of the housing 100, of the flat surface p of the sealing ring 7, and a part, facing the accommodation cavity of the housing 100, of the arc surface q of the sealing ring 7, to form the conducting layer 8. A part, facing away from the accommodation cavity of the housing 100, of the flat surface p of the sealing ring 7 is provided with a bonding surface, for bonding to the first flanging structure 31 and the second flanging structure 41. Certainly, disposing of the sealing ring 7 is not limited thereto. For example, the sealing ring 7 may alternatively be clamped at joints between the cover 2 and the two first side plates 3 and between the cover 2 and the two second side plates 4, or may be prepared at joints between the cover 2 and the two first side plates 3 and between the cover 2 and the two second side plates 4 through a glue dispensing and foaming process. During spray coating of the cover 2, the first side plates 3, and the second side plates 4, parts, to be electrically connected to the sealing ring 7, of the cover 2, the first side plates 3, and the second side plates 4 may be blocked and protected, to avoid impact of the spray coating on continuous connection and conduction between the cover 2, the first side plates 3, and the second side plates 4.

It should be noted that the housing 100 mentioned in embodiments of this application may alternatively be used in a power distribution box, a switch box, or the like, and is not limited to being used in a photovoltaic inverter.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A housing for a power device, wherein the housing comprises a bottom plate, a cover, two first side plates, and two second side plates, the bottom plate and the cover are arranged opposite to each other along a first direction, the two first side plates are arranged opposite to each other along a second direction, the two second side plates are arranged opposite to each other along a third direction, and the first direction, the second direction, and the third direction are perpendicular to each other, wherein
a plurality of first through holes are arranged at spacings on at least one of the two first side plates, each first through hole is configured to accommodate one first screw, a first nut and a first gasket are separately sleeved on the first screw, and the first gasket, the cover, the first side plate, and the first nut are sequentially stacked along a penetration direction of the first through hole; and
a plurality of second through holes are arranged at spacings on at least one of the two second side plates, each second through hole is configured to accommodate one second screw, a second nut, a second gasket, and a reinforcing piece are separately sleeved on the second screw, and the second gasket, the cover, the second side plate, the reinforcing piece, and the second nut are sequentially stacked along a penetration direction of the second through hole.

2. The housing according to claim 1, wherein lengths of the two first side plates along the third direction are less than lengths of the two second side plates along the second direction.

3. The housing according to claim 1, wherein the bottom plate, the two first side plates, and the two second side plates enclose an accommodation cavity, and the accommodation cavity is configured to accommodate an electrical component, wherein
each first side plate is connected to the two second side plates in a third fastening manner, the bottom plate is connected to the two first side plates and the two second side plates in the third fastening manner, and at least one of a fastening force of the first fastening manner or a fastening force of the second fastening manner is less than a fastening force of the third fastening manner.

4. The housing according to claim 3, wherein the third fastening manner comprises welding or integral forming, the two pairs of side plates are sequentially fastened to each other, and each side plate is fastened to the bottom plate.

5. The housing according to claim 1, wherein at least one of the two first side plates comprises a first flanging structure, the first flanging structure is arranged on an outer side of the housing, a projection of the cover covers a projection of the first flanging structure along the first direction, the first flanging structure comprises the plurality of first through holes, and the plurality of first through holes are sequentially arranged at spacings on the first flanging structure along the third direction, wherein
each first through hole penetrates the first flanging structure along the first direction, and the first gasket, the cover, the first flanging structure, and the first nut are sequentially stacked along the first direction.

6. The housing according to claim 1, wherein at least one of the two second side plates comprises a second flanging structure, the second flanging structure is arranged on an outer side of the housing, a projection of the cover covers a projection of the second flanging structure along the first direction, the second flanging structure comprises the plurality of second through holes, and the plurality of second through holes are sequentially arranged at spacings along the second direction, wherein
each second through hole penetrates the second flanging structure along the first direction, and the second gasket, the cover, the second flanging structure, the reinforcing piece, and the second nut are sequentially stacked along the first direction.

7. The housing according to claim 1 or 5, wherein the cover comprises at least one third flanging structure, and a projection of each third flanging structure covers the first flanging structure or the second flanging structure along the first direction.

8. The housing according to claim 7, wherein each third flanging structure comprises a plurality of fourth through holes, wherein
along the first direction, each fourth through hole penetrates one third flanging structure, and a projection of each fourth through hole overlaps a projection of one first through hole or a projection of one second through hole.

9. The housing according to claim 1, wherein the housing comprises a sealing ring, and the sealing ring is disposed at joints between the cover and the two first side plates and between the cover and the two second side plates.

10. The housing according to claim 12, wherein a conducting layer is disposed on an inner surface of the sealing ring, and the cover is electrically connected to the two first side plates and the two second side plates through the conducting layer.

11. The housing according to claim 1, 5, or 6, wherein a distance between two adjacent first through holes among the plurality of first through holes is greater than a distance between two adjacent second through holes among the plurality of second through holes.

12. The housing according to claim 1, wherein a quantity of first through holes on the first side plate is less than a quantity of second through holes on the second side plate.

13. The housing according to claim 5 or 6, wherein a quantity of first through holes on the first flanging structure is less than a quantity of second through holes on the second flanging structure.

14. A photovoltaic inverter, comprising an electrical component and the housing for a power device according to any one of claims 1 to 13, wherein the housing is configured to accommodate the electrical component, and the electrical component comprises a plurality of power transistors.
